# EUROPEAN PATENT APPLICATION

(11) **EP 4 701 348 A1**
(43) Date of publication of application: **25.02.2026**
(21) Application number: 24195935.2
(22) Date of filing: 22.08.2024
(51) Int. Cl.: H05K 1/02

(54) **PRINTED CIRCUIT BOARD, ELECTRONIC SYSTEM AND PROCESS FOR MANUFACTURING AN ELECTRONIC SYSTEM**

(71) Applicant: Valeo Comfort and Driving Assistance, 94000 Créteil (FR)
(72) Inventor: NIBBARAGANDLA, Rajinikanth-Reddy, 94000 Créteil (FR); RANA, Gyana-Ranjan, 94000 Créteil (FR)
(74) Representative: Delaval, Guillaume Laurent

(57) **Abstract**

The invention relates to a printed circuit board (10).

According to the invention, the printed circuit board comprises a hole at least partially filled with a metal plate (12) having two opposites sides including a first side and a second side, the first side being configured to contact an electronic device (14) and the second side being configured to contact a heat sink (16).

## Description

### TECHNICAL FIELD OF THE INVENTION

The present invention relates to printed circuit board used, for example, in microelectronics, an electronic device comprising the printed circuit board, and a process for manufacturing the same.

More particularly, it concerns a printed circuit board comprising a hole at least partially filled with a metal plate configured to contact an electronic device and a heat sink.

The invention applies particularly advantageously to electronic systems, in which stable heat dissipation can be achieved through a simple structure and process.

### BACKGROUND INFORMATION AND PRIOR ART

Electronic systems are composed of a plurality of electronic components. These electronic components are typically mounted on a printed circuit board.

The continuing miniaturization of electronic systems increases the density of electronic components mounted on the printed circuit board.

As a result, more and more heat is generated within electronic systems by the operation of these electronic components.

It is required to disperse and discharge heat generated from electronic components mounted on the printed circuit board.

To this end, today's electronic systems comprise a heat dissipation structure in which heating elements - i.e. the electronic components - are disposed on a first surface of the printed circuit board and a heat sink is disposed on a second surface of the printed circuit board.

The heat dissipation structure typically comprises holes, also known as thermal vias, in the printed circuit board connecting the first surface to the second surface of the circuit board. In this heat dissipation structure, the heating elements are thus disposed on the openings of the thermal vias in the first surface and the heat sink is positioned on the openings of the thermal vias in the second surface. As a result the thermal vias connect the heating elements to the heat sink. The heat sink may thus receive the heat generated from the heating elements through the heat dissipation structure and disperse and discharge the heat to the outside of the electronic system.

However, thermal vias are not sufficiently efficient to transfer the heat of the electronic components to the heat sink resulting in a dramatic increase in temperature in the electronic system.

A number of solutions have been found to address this technical problem.

The internal surface of the thermal vias may be covered with a conductive material such as copper. Alternatively, the thermal vias may be filled with a conductive material such as copper. However, those solutions poorly address the technical problem.

In order to more efficiently discharge the heat to the outside of the electronic system, document US9668336B1 discloses an electronic system comprising a printed circuit board with a heat-generating component and an embedded coin board. In this document, a first opening is disposed in a heat-generating component and a second opening having the same dimensions than the first opening is drilled in a printed circuit board. A copper coin is then introduced in the heat-generating component and in the printed circuit board through the two aligned openings. As a drawback, in this electronic system, the heat-generating component needs to be designed in order to encircle the copper coin, thus limiting the use of this heat dissipating structure.

### SUMMARY OF THE INVENTION

Therefore, there is a need for a simple and efficient heat dissipating structure that can fits a broad variety of electronic components.

In this context, the invention proposes a printed circuit board comprising a hole at least partially filled with a metal plate having two opposites sides including a first side and a second side, the first side being configured to contact an electronic device and the second side being configured to contact a heat sink.

The printed circuit board provides an efficient heat transfer from the electronic device to the heat sink by connecting the lower surface of the electronic device to the upper surface of the heat sink. Moreover, as the design of the metal plate optimizes the contact between the metal plate and the electronic device on the first side of the printed circuit board and between the metal plate and the heat sink on the second side of the printed circuit board, it allows to save material during the manufacture of an electronic system comprising such a heat dissipating architecture.

According to other optional (and therefore non-limiting) features:
- the metal plate comprises at least two portions extending in plane view, each portion being connected to at least one of the other portions and extending from each other at an angle.
- the metal plate is generally Z-shaped in plane view.
- the metal plate is generally H-shaped in plane view.
- metal plate is generally I-shaped in plane view.
- the metal plate is generally X-shaped in plane view.
- the metal plate is generally O-shaped in plane view.
- the metal plate is generally shaped as a cross in plane view.
- the metal plate comprises copper, silver or gold.

The invention also proposes an electronic system comprising:
- a printed circuit board,
- an electronic device connected to the first side of the metal plate,
- a heat sink connected to the second side of the metal plate. According to other optional (and therefore non-limiting) features:
- the electronic device is a network access device.
- the shape of the metal plate being is further configured so that the surface of the first side of the metal plate matches the surface of the electronic device in contact with the printed circuit board.
- the heat sink comprises aluminium.
- a thermal pad is comprised between the metal plate and the heat sink.

The invention also proposes a process for manufacturing an electronic system, comprising the following steps:
E11) providing a printed circuit board and a metal plate,
E21) machining the printed circuit board to obtain a hole having the plane view shape and dimensions of the metal plate, connecting a first side of the printed circuit board to a second side of the printed circuit board,
E31) disposing the metal plate in the hole obtained at step E21)
E41) contacting an electronic device to the first side of the metal plate,
E51) contacting a heat sink to the second side of the metal plate.

According to other optional (and therefore non-limiting) features:
- the metal plate is inserted in the printed circuit board through the first side of the printed circuit board.
- during step E21), the printed circuit board is machined so that the shape of the hole in plane view matches the surface of the electronic device in contact with the printed circuit board.
- the process for manufacturing an electronic system further comprises a step E42) during which a thermal pad is disposed on the second side of the metal plate before initiating step E51).

The various features, variants and embodiments of the invention can be combined with one another in various ways, as long as they are not incompatible or mutually exclusive.

### DETAILED DESCRIPTION OF EXAMPLE(S)

In addition, various other features of the invention are apparent from the appended description with reference to the drawings, which illustrate non-limiting embodiments of the invention and in which:
[Fig. 1] is a plane view representation of a printed circuit board according to an existing architecture,
[Fig. 2] is a plane section view representation of an electronic system according to one embodiment of the invention,
[Fig. 3] is a plane view representation of a printed circuit board according to one embodiment of the invention,
[Fig. 4] is a plane view representation of a printed circuit board according to another embodiment of the invention,
[Fig. 5] is a plane view representation of a printed circuit board according to another embodiment of the invention,
[Fig. 6] is a plane view representation of a printed circuit board according to another embodiment of the invention,
[Fig. 7] is a plane view representation of a printed circuit board according to another embodiment of the invention,
[Fig. 8] is a plane view representation of a printed circuit board according to another embodiment of the invention, and
[Fig. 9] is a summary diagram of a process for manufacturing an electronic system shown in [Fig. 2] according to one embodiment of the invention. Optional steps are in dotted lines.

It should be noted that in these figures, structural and/or functional elements common to the different variants may have the same references.

### Printed circuit board and electronic system

As is appropriate, detailed embodiments of the present disclosure are disclosed herein; however, it should be understood that the disclosed embodiments are only examples of the invention, which can be implemented in various and alternative forms. The figures do not necessarily represent a detailed design; some diagrams may be exaggerated or minimized to show an overview of the function. Therefore, the specific structural and functional details disclosed herein are not to be construed as limiting, but merely as a representative basis for teaching a person skilled in the art to use the present invention in a variety of ways.

It is understood that the specific devices and process illustrated in the accompanying drawings, and described in the following specification, are merely exemplary embodiments of the inventive concepts defined in the appended claims. Accordingly, the specific dimensions and other physical characteristics relating to the embodiments disclosed herein are not to be considered limiting, unless the claims expressly state otherwise.

In this document, the term "and/or", when used in a list of two or more items, means that any one of the items listed may be used alone, or that any combination of two or more items in the list may be used.

In this document, the term "in plane" refers to the plane of the printed circuit board unless otherwise specified.

The terms "the," "a," or "an," mean "at least one," and are not limited to "only one" unless explicitly indicated to the contrary. For example, "a component" includes embodiments having two or more such components unless the context clearly indicates otherwise.

In electronics and microelectronics, a printed circuit board (also known as PCB) is commonly used to hold and electrically connect a set of electronic components together, in order to create a complex electronic circuit. Printed circuit boards are usually made of one or several layer of a conductive material, for example copper, separated by an insulating material, for example fibreglass. The conductive layers are etched in order to obtain a plurality of conductive tracks connecting electrically the plurality of electronic components mounted on the printed circuit board.

One of the most commonly used fiberglass for low-frequency applications is FR4 which is a standard defined by NEMA (National Electrical Manufacturers Association) for a composite material composed of woven fiberglass cloth with an epoxy resin binder that is flame resistant. Among other materials used for printed circuit board, FR-5 is also known as the high temperature version of FR-4 epoxy laminate. FR-5 laminate uses multiple layers of woven glass cloth impregnated with an epoxy resin system for increased mechanical stability and heat resistance. The printed circuit board may also be made of G-10 material which is thermosetting industrial laminated plastic consisting of a woven glass cloth material and an epoxy resin matrix. G-10 has a high strength, low moisture absorption, and high level of electrical insulation and chemical resistance.

In order to evacuate the heat generated by the electronic components mounted of a first side of the printed circuit board, heat conductive paths are usually made in the printed circuit board. Thermally conductive paths may be obtained, for example, by depositing a thermally conductive layer in the plane of the printed circuit board, to evacuate the heat horizontally (to the side of the printed circuit board). Thermally conductive paths may also be obtained by manufacturing vias in the printed circuit board, which are plated-through holes that allow interconnections, and therefore adding thermally conductive path, between layers of the printed circuit board, to evacuate the heat vertically (from the first side of the printed circuit board to the second side of the printed circuit board). In order to enhance the thermal conductivity of the vias, the internal surface of the vias may be covered with a material having a high thermal conductivity. Alternatively, the vias may be filled with a material having a high thermal conductivity. Material with a high thermal conductivity comprises, for example, copper, silver or gold.

In order to evacuate more efficiently the heat from the electronic components, a heat sink is usually mounted on the second side of the printed circuit board, the electronic components and the heat sink being thermally connected by the vias.

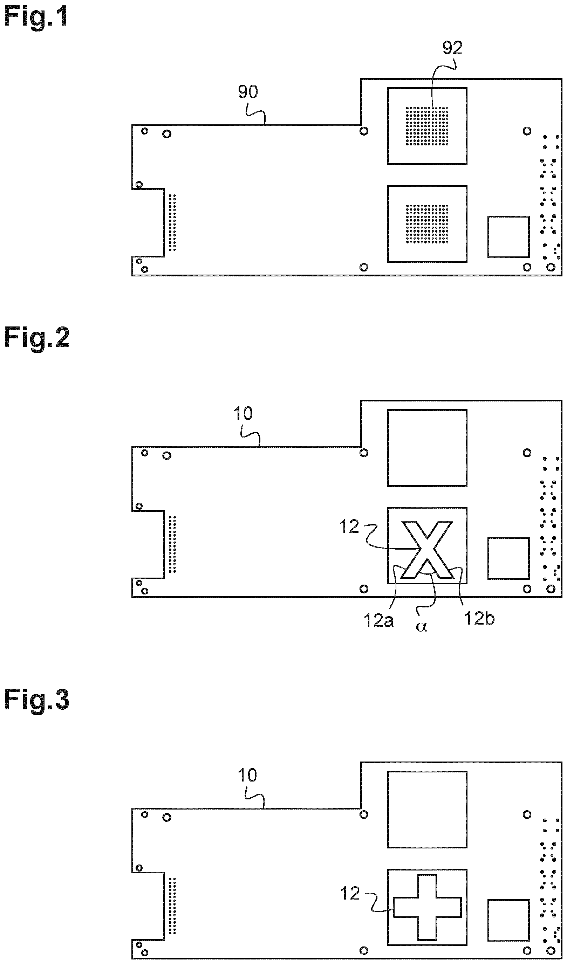

An example of an existing printed circuit board 90 comprising vias 92 is shown in [Fig. 1].

According to an embodiment of the invention, a printed circuit board 10 comprising a metal plate 12 is shown in [Fig. 2]. In the embodiment shown, the printed circuit board 10 comprises two opposites sides: a first side and a second side. The printed circuit board 10 is made of an insulating material, for example FR-4, FR-5 or G-10. At least the first side of the printed circuit board 10 is covered with a layer or tracks of a conductive material. The conductive material comprises, for example, copper, silver, gold or an alloy of at least two of these metals.

The printed circuit board 10 further comprises a hole whose in plane shape is configured to correspond to the in plane shape of the metal plate 12. The hole is configured to connect the first side to the second side of the printed circuit board 10. The metal plate 12 is configured to at least partially fills the hole of the printed circuit board 10. The metal plate 12 comprises at least two opposites sides comprising a first side and a second side. The metal plate 12 embedded in the printed circuit board 10 is further configured to allow contact at least one device, for example one electronic component, on the first side of the metal plate 12 and/or at least one device, for example a heat sink, on the second side of the metal plate.

As mentioned herein above, the metal plate 12 at least partially fills the hole intended for embedding the metal plate 12. Therefore, the first side (and/or the second side) of the metal plate 12 may be at the same height than the first side (and/or the second side respectively) of the printed circuit board 10 or at a different height than the printed circuit board. The metal plate 12 may protrude from the printed circuit board 10, or vice versa.

Advantageously, the metal plate 12 is a tri-dimensional heat dissipating structure. Therefore, the metal plate 12 evacuates heat more efficiently and allows better thermal contact with electronic devices and/or heat sink in contact with the metal plate 12 than thermal vias which are one-dimensional structures.

The metal plate 12 is defined by three dimensions: length, width, and thickness.

The thickness of the metal plate 12 is smaller than the quarter of the length of the metal plate 12 and smaller than the quarter of the width of the metal plate 12.

Thermal vias extend along a single dimension.

The metal plate preferably comprises a material having a high thermal conductivity, for example copper, silver, gold or an alloy of at least two of these metals.

In a preferred embodiment and in embodiments described below with reference to [Fig. 2-5], the metal plate 12 comprises at least two portions extending in plane view, each portion being connected to at least one of the other portions and extending from each other at a non-zero angle.

The presence of at least two different portions within the metal plate 12 extending from each other at a non-zero angle thus makes it possible to obtain a high degree of stability for the electronic components in contact with the metal plate 12, and an improved heat conduction between the electronic components and the metal plate 12.

Advantageously, the metal plate 12 may be provided in a broad variety of shapes suitable for different electronic components assemblies. Examples of shape are disclosed in the following embodiments.

In a first embodiment shown in [Fig. 2], the metal plate 12 is generally X-shaped in plane view. The metal plate 12 comprises a first portion 12a and a second portion 12b. Each portions has the shape of a parallelogram. The two portions 12a and 12b are connected to each other such that they share the same centre of symmetry and extend from each other with an angle α. The angle α is equal or greater to 1° and lower of equal to 179°. In the embodiment shown in [Fig. 1], the angle α is equal to 45°.

The second embodiment shown in [Fig. 3], is a particular case of the first embodiment wherein the angle α is equal to 90°. Therefore, the metal plate 12 has the shape of a cross.

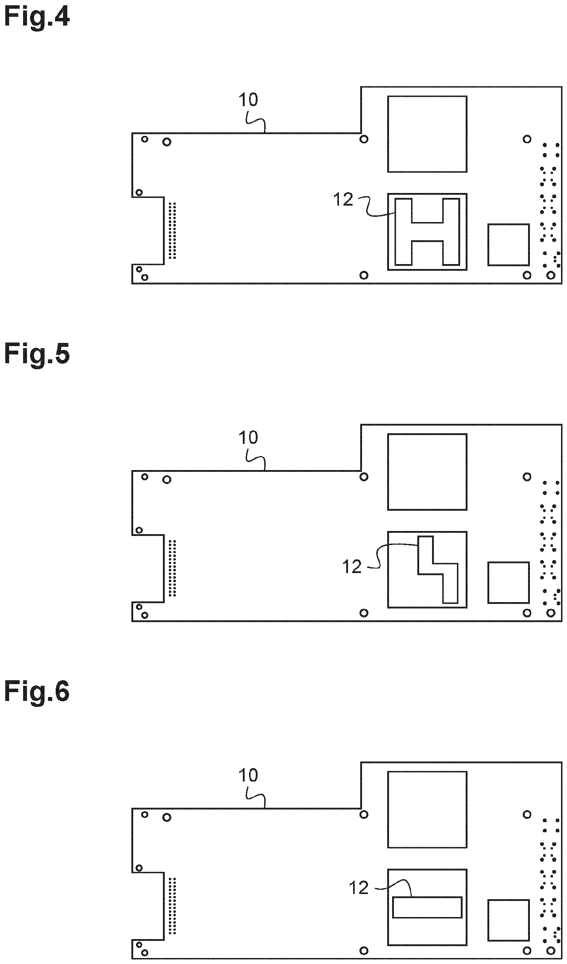

In a third embodiment shown in [Fig. 4], the metal plate 12 is generally H-shaped in plane view. In this embodiment, the metal plate 12 comprises three portions. Each portion has the shape of a rectangle. Two portions are parallel and are separated by a third portion extending from the other two portions with an angle equal to 90° and such that the metal plate 12 has two mirror planes perpendicular to each other.

In a fourth embodiment shown in [Fig. 5], the metal plate 12 is generally Z-shaped in plane view. In this embodiment, the metal plate 12 comprises three portions. Each portion has the shape of a rectangle. Two portions are parallel and are separated by a third portion extending from the other two portions with an angle equal to 90° and joining opposite sides of the two portions.

In a fifth embodiment shown in [Fig. 6], the metal plate 12 is generally I-shaped in plane view. In this embodiment, the metal plate 12 comprises one portion which has the shape of a rectangle.

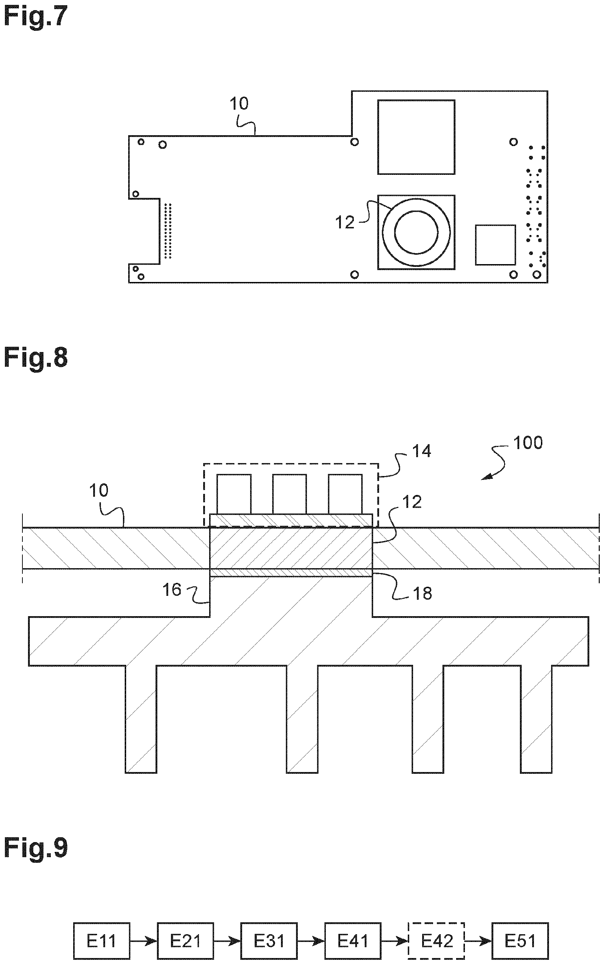

In a sixth embodiment shown in [Fig. 7], the metal plate 12 is generally O-shaped in plane view. In this embodiment, the metal plate 12 comprises one portion which has the shape of a ring.

An electronic system 100 is shown in [Fig. 8]. The electronic system 100 comprises:
- a printed circuit board 10 comprising a metal plate 12 according to one of the embodiments described herein above,
- an electronic device 14 in contact with the first side of the metal plate 12,
- a heat sink in contact 16 with the second side of the metal plate 12.

"In contact" means that the electronic device 14 (or the heat sink 16) makes thermal contact with the metal plate 12.

As mentioned herein before, the shape of the metal plate 12 may be one of the different shapes disclosed in the afore mentioned embodiments of the invention.

According to those embodiments, a most appropriate general shape (in Z, X, I, O, +, H) of the metal plate 12 is chosen to fit the shape of the electronic device 14.

Alternatively, the shape of the metal plate 12 may be configured so that the surface of the first side of the metal plate 12 matches the surface of the electronic device 14 in contact with the metal plate 12.

Advantageously, shaping the metal plate 12 to match the shape of the surface of the electronic device 14 in contact with the printed circuit board 10 provides a better thermal contact, and thus a better heat conduction, between the electronic device 14 and the metal plate 12.

In the same way, the shape of the shape of the metal plate 12 may be configured so that the surface of the second side of the metal plate 12 matches the surface of the heat sink 16 in contact with the metal plate 12.

Advantageously, shaping the metal plate 12 to match the shape of the surface of the heat sink 16 in contact with the printed circuit board 10 provides a better thermal contact, and thus a better heat conduction, between the heat sink 16 and the metal plate 12.

The electronic device 14 comprises at least one electronic component which produces heat during operation. In the preferred embodiment, the electronic device 14 is a network access device.

In the preferred embodiment, the heat sink 16 comprises a conductive mass of metal made, for example, in aluminium. The heat sink 16 is configured to make a strong thermal contact with the metal plate 12 in order to maximize heat transfer from the metal plate 12 to the heat sink 16.

In the preferred embodiment, the first side (and the second side) of the metal plate 12 is at the same height than the first side (the second side respectively) of the printed circuit board as shown in [Fig. 8].

In another embodiment, the electronic system 100 comprises a thermal pad 18 comprised between the metal plate 12 and the heat sink 16.

Advantageously, the thermal pad 18 enhances the efficiency of the thermal contact between the metal plate 12 and the heat sink 16.

### Process

The invention also relates to processes for manufacturing an electronic system such as the electronic system 100 shown in [Fig. 8] and comprising, as shown in [Fig. 9]:
a step E11) during which a printed circuit board 10 and a metal plate 12 are provided,
a step E21) during which the printed circuit board 10 is machined in order to obtain a hole having the plane view shape and dimensions of the metal plate 12, the metal plate 12 connecting a first side of the printed circuit board 10 to a second side of the printed circuit board 10,
a step E31) during which the metal plate 12 is positioned in the hole obtained at step E21).
a step E41) during which electronic device 14 is positioned in contact with the first side of the metal plate 12,
a step E51) during which a heat sink 16 is positioned in contact with the second side of the metal plate 12.

According to a preferred embodiment, the metal plate 12 is inserted in the printed circuit board 10 through the first side of the printed circuit board 10.

According to a preferred embodiment, during step E21), the printed circuit board 10 is machined so that the shape of the hole in plane view matches the surface of the electronic device 14 in contact with the printed circuit board 10.

According to a preferred embodiment, the process for manufacturing an electronic system further comprises a step E42) during which a thermal pad is disposed on the second side of the metal plate before initiating step E51).

It should be noted that in these figures, structural and/or functional elements common to the different variants may have the same references.

Various other modifications may be made to the invention within the scope of the appended claims.

As a variant, the printed circuit board is configured to combine a metal plate 12 according to one embodiment of the invention with thermal vias.

As a variant, the heat sink 16 comprises aluminium based alloys, copper or copper based alloys.

As a variant, the metal plate 12 is generally square shaped in plane view.

As a variant, the thermal pad 18 may be replaced with thermal paste or thermal putty.

## Claims

1. A printed circuit board (10) comprising a hole at least partially filled with a metal plate (12) having two opposites sides including a first side and a second side, the first side being configured to contact an electronic device and the second side being configured to contact a heat sink.

2. A printed circuit board (10) according to claim 1, wherein the metal plate (12) comprises at least two portions extending in plane view, each portion being connected to at least one of the other portions, said portion and said at least one of the other portions extending from each other at an angle.

3. A printed circuit board (10) according to claim 1 or 2, wherein the metal plate (12) is generally Z-shaped in plane view or generally H-shaped in plane view or generally I-shaped in plane view or generally X-shaped in plane view or generally O-shaped in plane view.

4. A printed circuit board (10) according to claim 1 or 2, wherein the metal plate (12) is generally shaped as a cross in plane view.

5. A printed circuit board (10) according to any of claims 1 to 4, wherein the metal plate (12) comprises copper, silver or gold.

6. An electronic system (100) comprising:
- a printed circuit board (10) according to any of claims 1 to 5,
- an electronic device (14) in contact with the first side of the metal plate,
- a heat sink (16) in contact with the second side of the metal plate.

7. An electronic system (100) according to claim 6, wherein the electronic device (14) is a network access device.

8. An electronic system (100) according to claim 6 or 7, the shape of the metal plate (12) being further configured so that the surface of the first side of the metal plate (12) matches the surface of the electronic device (14) in contact with the printed circuit board (10).

9. An electronic system (100) according to any of claims 6 to 8, wherein the heat sink (16) comprises aluminium.

10. An electronic system (100) according to any of claims 6 to 9, wherein the electronic system (100) comprises a thermal pad (18) comprised between the metal plate (12) and the heat sink (16).

11. A process for manufacturing an electronic system, comprising the following steps:
E11) providing a printed circuit board and a metal plate,
E21) machining the printed circuit board to obtain a hole having the plane view shape and dimensions of the metal plate, the metal plate connecting a first side of the printed circuit board to a second side of the printed circuit board,
E31) disposing the metal plate in the hole obtained at step E21)
E41) contacting an electronic device to the first side of the metal plate,
E51) contacting a heat sink to the second side of the metal plate.

12. A process for manufacturing an electronic system according to claim 11, wherein the metal plate is inserted in the printed circuit board through the first side of the printed circuit board.

13. A process for manufacturing an electronic system according to claim 11 or 12, wherein during step E21), the printed circuit board is machined so that the shape of the hole in plane view matches the surface of the electronic device in contact with the printed circuit board.

14. A process for manufacturing an electronic system according to any of claims 11 to 13, further comprising a step E42) during which a thermal pad is disposed on the second side of the metal plate before initiating step E51).
